# EUROPÄISCHE PATENTSCHRIFT

(11) **EP 0 321 752 B1**
(45) Veröffentlichungstag und Bekanntmachung des Hinweises auf die Patenterteilung: **19.10.1994**
(21) Anmeldenummer: 88120008.3
(22) Anmeldetag: 30.11.1988
(51) Int. Cl.: H01R 9/24, H02G 15/076, H04Q 1/14, H01R 4/24

(54) **Einrichtung zum Anschliessen und Verbinden von elektrischen Leitungen**
Device to connect and join electrical conductors together
Dispositif pour raccordement et connexion de lignes électriques

(30) Priorität: 23.12.1987 DE 8716918 U
(43) Veröffentlichungstag der Anmeldung: 28.06.1989
(73) Patentinhaber: SIEMENS AKTIENGESELLSCHAFT, 80333 München (DE)
(72) Erfinder: Scholtholt, Hans, Ing.-Grad., D-8044 Lohof (DE); Steiner, Ewald, Ing.-Grad., D-8137 Berg 3 (DE)

(56) Entgegenhaltungen:
- EP-A- 0 200 883
- DE-A- 2 309 579
- DE-B- 1 196 245
- US-A- 3 899 237

## Beschreibung

Die Erfindung bezieht sich auf eine Einrichtung zum Anschließen und Verbinden von ankommenden und abgehenden elektrischen Leitungen insbesondere in Verteilern von Fernsprechanlagen. Eine derartige Einrichtung ist z. B. durch die DE-OS 27 25 551 bekannt geworden. Danach sind die elektrischen Leitungen an länglichen Anschlußleisten angeschlossen, die an ihren Enden mittels Schrauben an einem Aufnahmegestell befestigt sind.

Eine weitere Einrichtung ist durch die EP-A-0 200 883 bekannt worden. Noch eine derartige Einrichtung ist aus US-A-3 899 237 bekannt.

Der Erfindung liegt die Aufgabe zugrunde, das Befestigen der Anschlußleisten zu vereinfachen.

Diese Aufgabe wird durch die Erfindung gemäß Anspruch 1 gelöst. Die Anschlußleisten können nun in einfacher Weise zunächst an einem Ende auf einen Seitenschenkel so aufgesetzt werden, daß die Befestigungselemente in die Ausnehmungen hineinragen. Daraufhin wird die Anschlußleiste bis zum Verrasten des anderen Endes gegen den zweiten Seitenschenkel geschwenkt. Durch die formschlüssige Verbindung wird das Trägerteil so stabilisiert, daß es sehr dünn gehalten werden kann. Dadurch ist es möglich, das Trägerteil aus dünnem Blech kostengünstig zu biegen. Ein derartiges Blech kann an Erde gelegt werden. Dadurch ist es möglich, Erdungsbleche für Schutzstecker der Anschlußleisten über das Trägerteil einfacher zu erden.

Durch die Bildung der Erfindung nach Anspruch 1 wird zwischen benachbarten Trägerteilen unterhalb der Seitenstege ein Verdrahtungsraum für an die Anschlußleiste anzuschließende Rangierdrähte gebildet. Es ergibt sich gleichzeitig eine breite Auflagefläche für die Anschlußleisten.

Durch die Weiterbildung nach Anspruch 1 erstreckt sich die Ausnehmung im wesentlichen parallel zur Anschlußleiste. Die Ausnehmungen sind für die Montageperson gut sichtbar, so daß die Befestigungselemente leichter eingefädelt werden können. Die hakenartigen Befestigungselemente hintergreifen mit entsprechenden Vorsprüngen den Seitensteg auf einer Länge, die größer sein kann als das Blech dick ist. Auf diese Weise wird eine sichere Verriegelung erreicht. Die Rastelemente auf der anderen Seite überragen den Seitensteg und sind dadurch gut zugänglich. Sie können von außen her leicht entriegelt werden.

Im folgenden wird die Erfindung anhand eines in der Zeichnung dargestellten Ausführungsbeispiels näher erläutert.

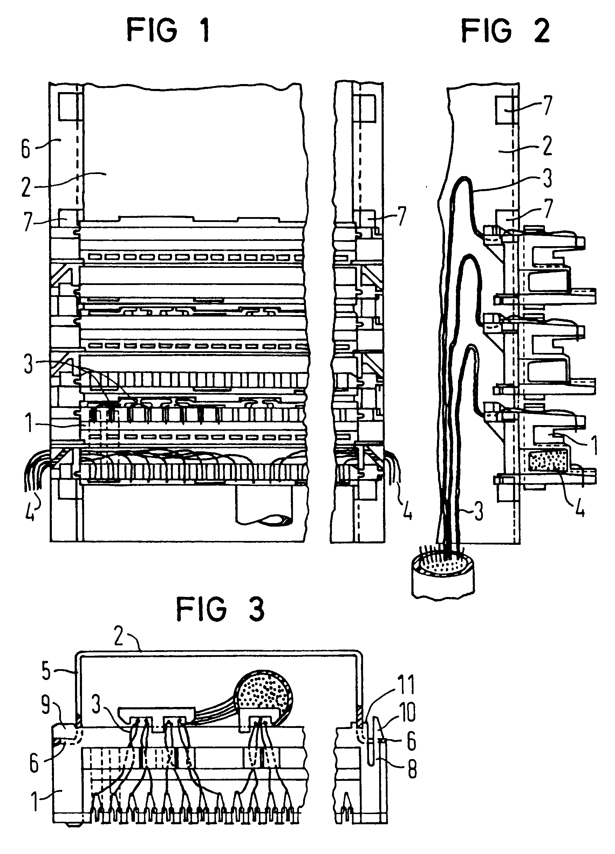

Die Figuren 1, 2 und 3 zeigen in drei verschiedenen Ansichten einen Verteilerblock, der aus längsseitig aneinander gereihten Anschlußleisten 1 und einem Trägerteil 2 für die Anschlußleisten 1 besteht. An die Anschlußleisten sind ankommende elektrische Leitungen 3 und abgehende Leitungen 4 angeschlossen. Das Trägerteil 2 ist aus Blech u-förmig gebogen. Die Anschlußleisten 1 sind von länglicher Gestalt und quer zur Längsrichtung des Trägerteils 2 an dessen Seitenschenkeln 5 befestigt. Deren freie Enden sind rechtwinklig nach außen zu einem Seitensteg abgebogen. Im Bereich dieser Biegung sind in dem Seitenschenkel 5 mit dem Seitensteg 6 Ausnehmungen 7 vorgesehen, in die Rastelemente 8 und Befestigungselemente 9 der Anschlußleiste 1 eingreifen. Die Rastelemente 8 und Befestigungselemente 9 sind einstückig mit einem Isolierstoffkörper der Anschlußleiste 1 verbunden. Die Befestigungselemente 9 sind hakenartig ausgebildet und können durch Schwenken der Anschlußleiste 1 in die entsprechenden Ausnehmungen 6 derart eingesetzt werden, daß zwischen dem entsprechenden Seitenschenkel 5 und der Anschlußleiste 1 ein Formschluß entsteht. Die Rastelemente 8 am anderen Ende der Anschlußleisten 1 ragen in die Richtung der Seitenschenkel 5. Sie weisen eine gefederte Rastnase 10 auf, die den Seitensteg von innen her hintergreift. Auf der Seite der Rasthaken 8 weist die Anschlußleiste 1 Vorsprünge 11 auf, die den Seitenschenkel 5 an der Ausnehmung 7 gabelförmig umgreifen und damit formschlüssig fixieren. Dies wird dadurch ermöglicht, daß die Ausnehmung 7 sich zu beiden Seiten der Biegung für den Seitensteg 6 erstreckt.

## Patentansprüche

1. Einrichtung zum Anschließen und Verbinden von ankommenden und abgehenden elektrischen Leitungen (3, 4) insbesondere in Verteilern von Fernsprechanlagen, wobei die Einrichtung Anschlußleisten (1) mit Anschlußelementen für die ankommenden und abgehenden Leitungen aufweist und wobei die Anschlußleisten (1) an einem Trägerteil (2) der Einrichtung befestigt sind,
wobei das Trägerteil (2) aus dünnem Material kanalartig ausgebildet ist, wobei
der Abstand von Seitenschenkeln (5) des Trägerteils (2) ungefähr gleich der Länge der Anschlußleisten ist, daß diese auf die Enden der Seitenschenkel (5) des Trägerteils (2) aufgesetzt sind, wobei
die Seitenschenkel (5) Ausnehmungen (7) zum Befestigen der Anschlußleisten (1) aufweisen, wobei
Isolierstoffkörper der Anschlußleisten einstückig Befestigungselemente (9) und Rastelemente (8) aufweisen, die in die Ausnehmungen (7) eingreifen und wobei
die Seitenschenkel (5) und die Anschlußleisten (1) miteinander verbunden sind.
**dadurch gekennzeichnet**,
daß die freien Enden der Seitenschenkel (5) als Seitenstege (6) ausgebildet sind, die nach außen hin parallel zur Basis des Trägerteils (2) abgewinkelt sind,
daß die Ausnehmungen (7) zumindest abschnittsweise sowohl im Bereich des Seitenstegs (6) als auch des Seitenschenkels (5) liegen,
daß die Befestigungselemente (9) an einem Ende der Anschlußleiste (1) hakenartig ausgebildet sind und den zugehörigen Seitensteg (6) hintergreifen,
daß die Rastelemente (8) am anderen Ende der Anschlußleiste (1) als Rasthaken ausgebildet sind, die mit einer gefederten Rastnase (10) den Seitensteg (6) von innen her hintergreifen und daß die Anschlußleiste (1) gabelförmige Vorsprünge (11) aufweist, die den Seitenschenkel (5) des Trägerteils (2) im Bereich der Ausnehmung umgreifen.

## Claims

1. Device for attaching and connecting incoming and outgoing electrical lines (3, 4), especially in distribution frames of telephone systems, the device exhibiting terminal strips (1) with terminal elements for the incoming and outgoing lines, and the terminal strips (1) being secured to a carrier part (2) of the device,
the carrier part (2) being formed from thin material in the manner of a channel,
the spacing of lateral limbs (5) of the carrier part (2) being approximately equal to the length of the terminal strips, so that the latter are fitted onto the ends of the lateral limbs (5) of the carrier part (2),
the lateral limbs (5) exhibiting recesses (7) for securing the terminal strips (1),
insulating-material bodies of the terminal strips exhibiting in integral fashion securing elements (9) and detent elements (8), which engage into the recesses (7), and
the lateral limbs (5) and the terminal strips (1) being connected to one another,
characterized in that
the free ends of the lateral limbs (5) are formed as lateral webs (6), which are angled off outwards parallel to the base of the carrier part (2),
in that the recesses (7) lie at least portionwise within the region of the lateral web (6) and also of the lateral limb (5),
in that the securing elements (9) are formed in hook-like fashion on one end of the terminal strip (1) and engage behind the associated lateral web (6),
in that the detent elements (8) are formed at the other end of the terminal strip (1) as detent hooks which, by a sprung detent lug (10), engage from the inside behind the lateral web (6),
and in that the terminal strip (1) exhibits fork-shaped projections (11) which embrace the lateral limb (5) of the carrier part (2) in the region of the recess.

## Revendications

1. Dispositif pour raccorder et connecter des lignes électriques d'arrivée et de départ (3,4) notamment dans des répartiteurs d'installations téléphoniques, le dispositif comportant des barrettes de connexion (1) pourvues d'éléments de raccordement pour les lignes d'arrivée et de départ, dans lequel les barrettes de raccordement (1) sont fixées à une partie de support (2) du dispositif, la partie de support (2) est réalisée sous la forme d'un canal en un matériau mince, la distance de branches latérales (5) de la partie de support (2) est approximativement égale à la longueur des barrettes de connexion, ces dernières étant montées sur les extrémités des branches latérales (5) de la partie de support (2), et
les branches latérales (5) comportent des évidements (7) pour la fixation des barrettes de connexion (1),
les corps en matériau isolant des barrettes de connexion possèdent des éléments de fixation (9) et des éléments d'encliquetage (8), qui en sont solidaires et qui s'engagent dans les évidements (7), et
les branches latérales (5) et les barrettes de connexion (1) sont reliées entre elles,
caractérisé par le fait
que les extrémités libres des branches latérales (5) sont réalisées sous la forme de barrettes latérales (6) qui sont repliées vers l'extérieur parallèlement à la base de la partie de support (2),
que les évidements (7) sont situés au moins par endroits aussi bien dans la zone de la barrette latérale (6) que dans la zone de la branche latérale (5),
que les éléments de fixation (9) sont formés sous la forme de crochets sur une extrémité de la barrette de connexion (1) et s'engagent derrière la barrette latérale associée (6),
que les éléments d'encliquetage (8) situés sur l'autre extrémité de la barrette de connexion (1) sont formés sous la forme de crochets d'encliquetage, qui, au moyen d'un bec d'encliquetage suspendu élastiquement (10), s'engagent, à partir de l'intérieur, derrière la barrette latérale (6), et
que la barrette de connexion (1) possède des appendices saillants en forme de fourches (11), qui enserrent la branche latérale (5) de la partie de support (2) au voisinage de l'évidement.
